# EUROPEAN PATENT SPECIFICATION

(11) **EP 0 948 034 B1**
(45) Date of publication and mention of the grant of the patent: **05.01.2005**
(21) Application number: 98830206.3
(22) Date of filing: 03.04.1998
(51) Int. Cl.: H01L 21/3065, H01L 21/762

(54) **A method for manufacturing an SOI wafer**
Ein Verfahren für die Herstellung einer SO1-Scheibe
Méthode pour la fabrication d'une plaquette S01

(43) Date of publication of application: 06.10.1999
(73) Proprietor: STMicroelectronics S.r.l., 20041 Agrate Brianza (Milano) (IT)
(72) Inventor: Montanini, Pietro, 20122 Melegnano (IT); Villa, Flavio, 20159 Milano (IT); Barlocchi, Gabriele, 20010 Cornaredo (IT)
(74) Representative: Cerbaro, Elena, Dr.

(56) References cited:
- FR-A- 2 489 041
- GB-A- 2 156 149
- PATENT ABSTRACTS OF JAPAN vol. 014, no. 105 (E-0895), 26 February 1990 & JP 01 307241 A (CANON INC), 12 December 1989

## Description

The present invention relates to an improved method for manufacturing an SOI wafer.

As is known, according to a solution currently very widespread in the micro-electronics industry, the substrate of integrated devices is obtained from wafers of monocrystalline silicon. In the last few years, as an alternative to wafers consisting of silicon alone, composite wafers, so-called "SOI" (Silicon-on-Insulator) wafers have been proposed, comprising two silicon layers, one of which is thinner than the other, separated by a silicon oxide layer.

A method for manufacturing SOI wafers is the subject of European patent application no. 98830007.5 filed on 13.1.98 and published as EP-A-0 929 095 in the name of the same applicant, and is described hereinafter with reference to figures 1-9.

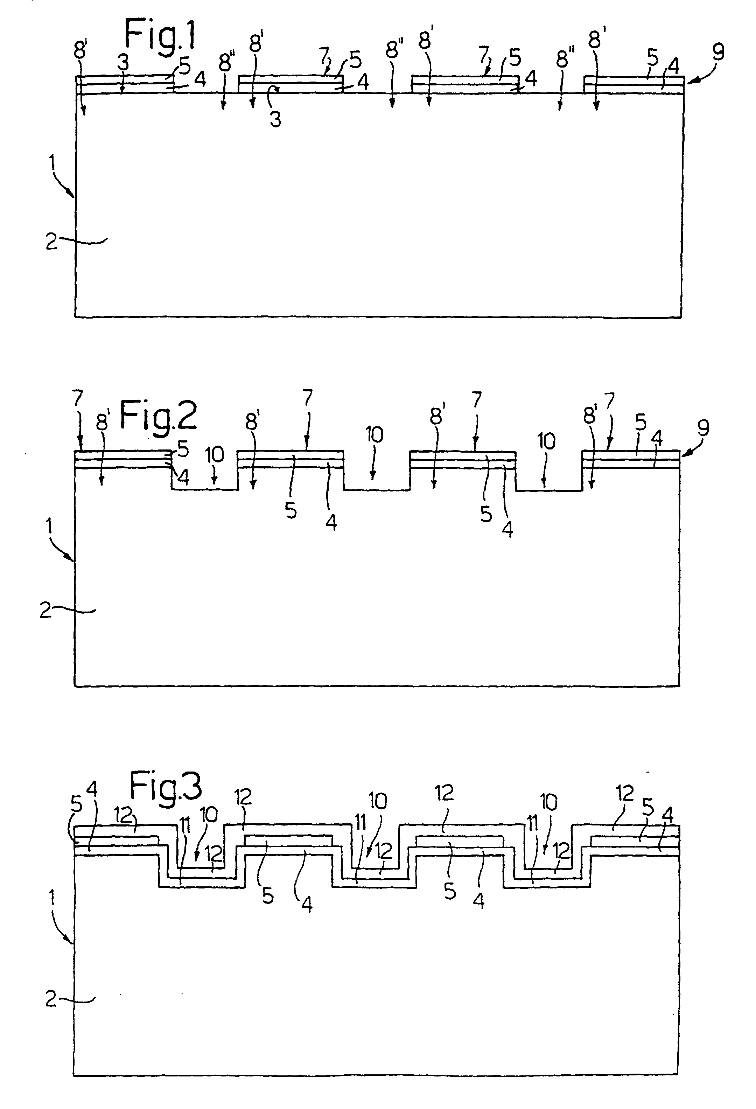

According to this method, on a surface 3 of a monocrystalline silicon region 2, a first silicon oxide layer is initially grown having a thickness for example comprised between 200 and 600 Å; a first silicon nitride layer with a thickness of between 900 and 1500 Å is then deposited. Using a resist mask, dry etching is carried out of the uncovered portions of the first oxide layer and of the first nitride layer, and the resist mask is then removed, providing the intermediate structure in figure 1. In figure 1, the wafer thus obtained is indicated 1 as a whole, and the portions of the first oxide layer and of the first nitride layer which have remained after the dry etching are indicated at 4 and 5, and define respective first protective regions 7 which cover first portions 8' of the monocrystalline silicon region 2.

The first protective regions 7 form a hard mask, indicated at 9, which is used to etch the monocrystalline silicon region 2 at second portions 8" not covered by the mask, such as to form initial trenches 10 (figure 2), which have depths comprised between 0.5 and 5 µm, depending on the features required for the buried oxide layer to be produced.

Subsequently, as shown in figure 3, the wafer 1 is subjected to oxidation to form a second oxide layer 11, which has a thickness comprised for example between 200 and 600 Å, covering the walls and the base of the initial trenches 10, and a second silicon nitride layer 12 is then deposited, having a thickness of between 900 and 1500 Å.

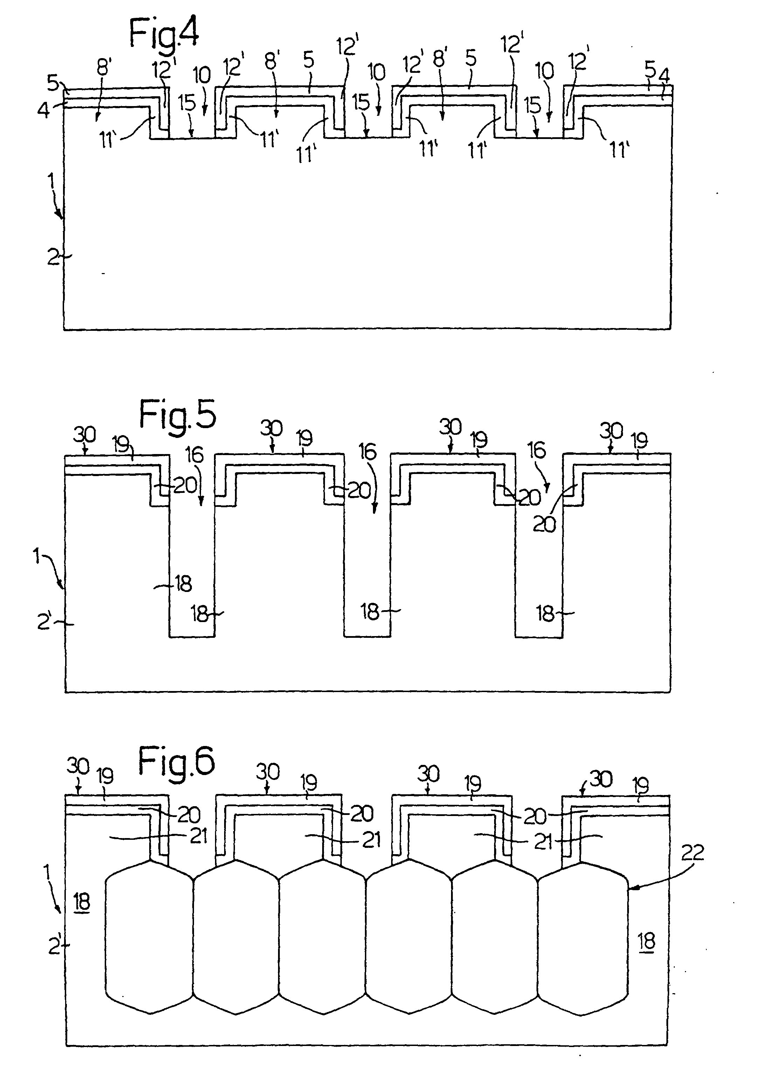

Thereafter, layers 12 and 11 are anisotropically etched without mask. Owing to the anisotropy of the etching, the horizontal portions are removed from second silicon nitride layer 12 and second oxide layer 11 on the bottom of initial trenches 10, and above portions 4 and 5, providing the intermediate structure of figure 4 wherein regions 8' are still covered above by the mask 9 and laterally (on the vertical walls of initial trenches 10) by portions 11' and 12' of oxide and nitride; on the other hand monocrystalline silicon region 2 is bare on the bottom 15 of the initial trenches 10.

Uncovered silicon at the bottom 15 of initial trenches 10 is then etched away, in order to deepen the initial trenches 10 until final trenches 16 of the required depth are obtained. In particular, the depth of the final trenches 16 (like that of the initial trenches 10) determines the dimensions of the buried oxide layer to be obtained, and thus the electrical characteristics of the SOI wafer, as explained hereinafter, and the depth is therefore determined on the basis of the specifications provided for the final SOI wafer.

The monocrystalline silicon region now comprises a base portion indicated at 2', and a plurality of "columns" 18, which extend vertically from the base portion 2'. Thus the intermediate structure of figure 5 is obtained, wherein nitride portions 5 and 12' are no longer separated from one another, and are indicated at 19, and oxide portions 4 and 11' now indicated at 20, are also no longer separated from one another, and, together with portions 19, form second protective regions 30.

A thermal oxidation step is then carried out, such that the exposed silicon regions of the "columns" 18 are transformed into silicon oxide. In fact, oxide regions are gradually grown, consuming the silicon regions, starting from the lateral walls of final trenches 16, towards the interior of the columns, and partly also towards and inside base portion 2'. Since during oxidation the volume increases, oxide regions being formed gradually occupy the space of the final trenches 16, until they fill the latter completely and are joined to one another. The oxidation step ends automatically when the columns 18 have been completely oxidised (apart from the upper area or tip, indicated at 21, which is protected by second protective regions 30), forming a continuous buried oxide region 22, shown in figure 6, in which continuous vertical lines indicate the meeting surfaces of the oxide regions being formed from walls of two adjacent final trenches 16, in order to show expansion of the oxide.

Subsequently, by selective etching, second protective regions 30 are eliminated such as to uncover the tips 21 which are intended to form the nuclei for a subsequent epitaxial growth.

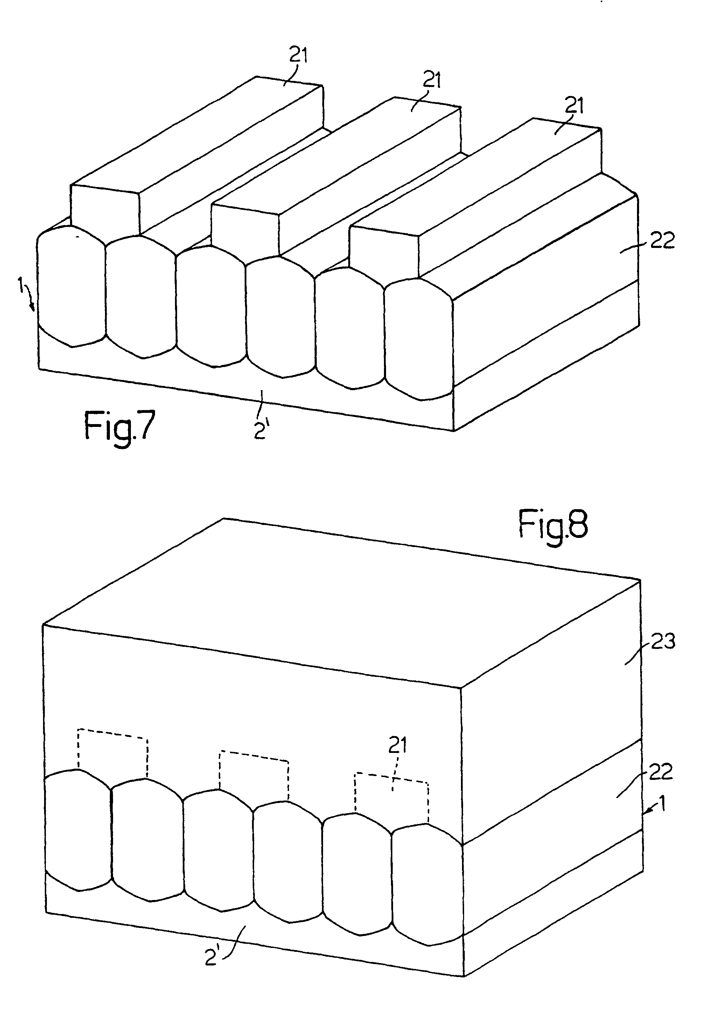

The structure of figure 7 is obtained, showing the three-dimensional structure of wafer 1 in this step. Subsequently, an epitaxial growth is carried out, the parameters of which are selected such as to prevent nucleation of silicon in the areas above buried oxide region 22, and a high ratio of lateral to vertical growth is selected, such as to obtain initially a horizontal growth of the silicon around tips 21 (and thus re-covering of the upper surface of buried oxide region 22), and then a vertical growth of an epitaxial layer 23. After an optional step of chemical-mechanical polishing to level the upper surface of wafer 1, the final structure of wafer 1 shown in figure 8 is then obtained.

Thereby, an SOI wafer can be produced using only process steps which are common in micro-electronics, at costs which are much lower than those of the processes currently used for manufacturing SOI substrates.

However, the above-described production method has the disadvantage that during the non-masked anisotropic etching step, oxide portions are uncovered, and, during the subsequent epitaxial step, give rise to extensive areas rich in crystallographic defects.

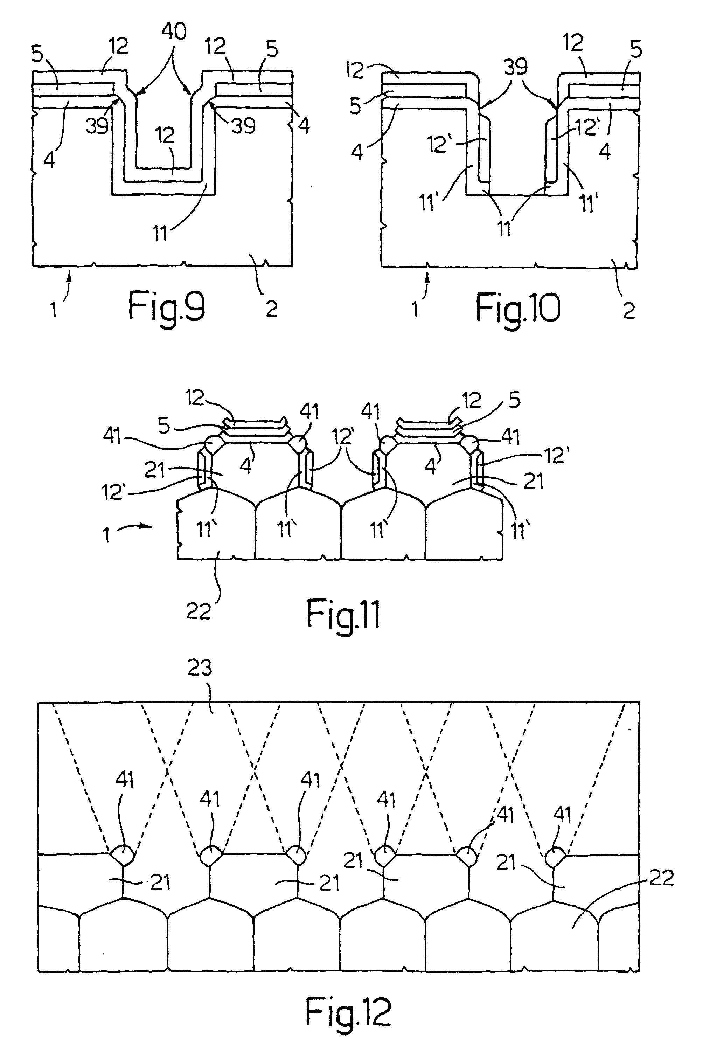

In particular, as shown in greater detail in figure 9 with reference to a single initial trench, growth of second oxide layer 11 takes place inter alia towards the interior of initial trench 10, forming steps 39. Consequently, when second silicon nitride layer 12 is deposited, it follows the inner profile of the lateral walls of initial trenches 10, and thus in turn forms a pair of steps 40 in each initial trench 10.

The presence of these steps 39, 40 causes, in the subsequent non-masked anisotropic etching of layers 12 and 11, removal not only of the horizontal portions of second silicon nitride layer 12 and second oxide layer 11 on the bottom of initial trenches 10 and above portions 4 and 5, but also of portions of second silicon nitride layer 12 forming the steps 40, thus leaving uncovered the portions of second oxide layer 11 which form the steps 39, as shown in figure 10.

Consequently, in the subsequent oxidation step for growing buried oxide region 22, there is undesirable growth of silicon oxide at the steps 39, forming oxide areas 41 (figure 11). These oxide areas 41 cause, in the subsequent epitaxial growth step, growing of extensive defectinve areas in epitaxial layer 23, delimited in figure 12 by broken lines.

The object of the present invention is thus to improve the above-described method, so as to eliminate crystallographic defects present in the epitaxial layer, and to obtain improvement of the electrical characteristics of the SOI wafer.

"Patent Abstracts of Japan, Vol. 014, No. 105 (E-0895), 26 February 1990 (1990-02-26) & JP-A-01 307241" discloses a method for manufacturing a substrate of complete SOI structure by selectively etching a buried layer, together with the etching of an epitaxial layer, and forming an insulating region by forming a thermally oxide film in the above etched region.

According to the present invention, an improved method for manufacturing SOI wafers is obtained, as defined in claim 1.

For allow better understanding of the present invention, a preferred embodiment is now described, purely by way of nonlimiting example, with reference to the attached drawings, in which:
- figures 1-6 show cross-sections through an SOI wafer in successive manufacturing steps according to a known method;
- figures 7 and 8 show prospective cross-sections in two successive steps of the known method;
- figures 9-12 show cross-sections through an SOI wafer, relative to the known production method; and
- figures 13-15 show cross-sections through an SOI wafer during manufacturing steps according to the present method.

The invention is based on modifying the method of etching the second portions 8" of monocrystalline silicon region 2, by preceding the anisotropic etching by an isotropic etching, so as to appropriately shape the initial trenches 10 near surface 3 of monocrystalline silicon region 2.

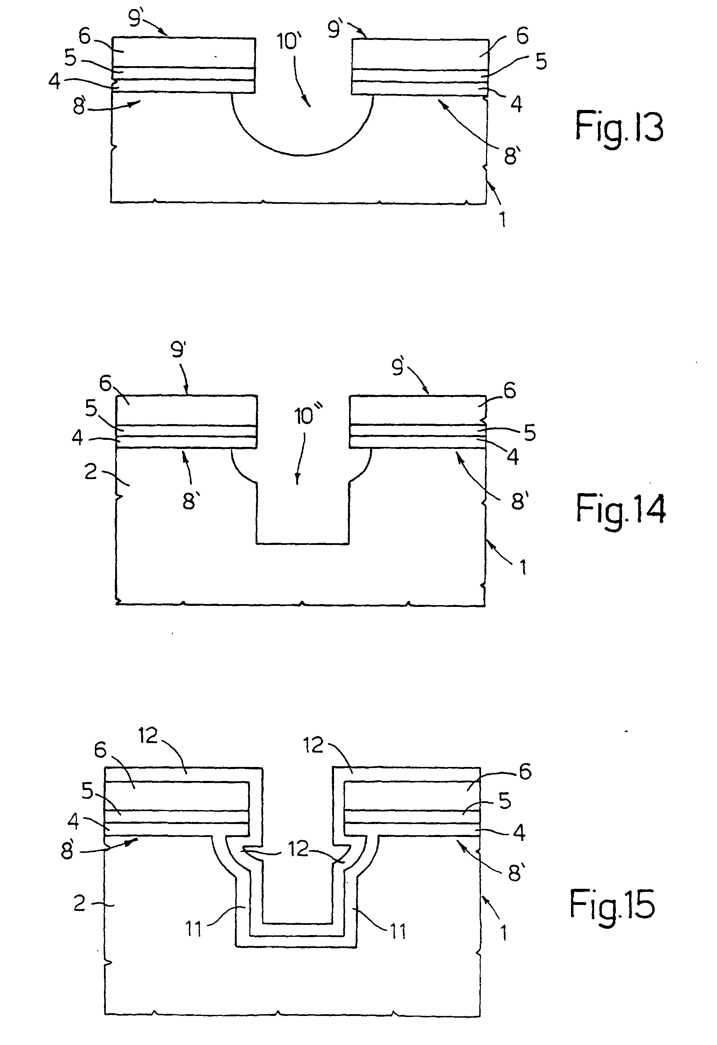

Advantageously, in particular, in the embodiment shown, on the first nitride layer 5, a TEOS (tetraethylorthosilicate) oxide layer 6 is deposited, having a thickness comprised for example between 5000 and 7000 Å, preferably of 6000 Å, which is subsequently defined together with first nitride layer 5 and first oxide layer 4, and forms the hard mask, indicated at 9' in figure 13.

Using hard mask 9', second portions 8'' of monocrystalline silicon region 2 are isotropically etched, to form partial trenches 10' (figure 13) . In particular, partial trenches 10' are cup-shaped, have a depth of 0.4-0.6 µm, preferably 0.5 µm. Owing to the etching isotropy, part of first portions 8' of monocrystalline silicon region 2 is also removed below first protective regions 7 defined by mask 9'.

In this step, TEOS layer 6 protects oxide regions 4 and silicon nitride regions 5. Isotropic etching is preferably carried out using a mixture of NF₃ and Ar in the following conditions: supply flow of NF₃ and Ar of 8 sccm (standard cube centimetres per minute) and 50 sccm, pressure of 250 mT (1 Torr = 133Pa), power of 500 W and magnetic field of 50 Gauss.

Immediately after isotropic etching, without removing wafer 1 from the treatment chamber, non-masked anisotropic etching similar to that previously described with reference to figure 2 is carried out. Anisotropic etching is advantageously carried out using a mixture of HBr, NF₃, He/O₂ and SiF₄, in the following conditions: supply flow of HBr, NF₃, He/O₂ and SiF₄ respectively of 32 sccm, 5 sccm, 8 sccm and 3 sccm, pressure of 125 mT, power of 650 W and magnetic field of 60 Gauss. This etching thus gives rise to an increase in the depth of partial trenches 10' in the vertical direction only, forming initial trenches 10". At the end, initial trenches 10" have an overall depth of between 0.6 and 4 µm, depending on the characteristics required for the buried oxide layer to be produced (figure 14).

Consequently, initial trenches 10" obtained after the isotropic and anisotropic etchings are approximately funnel-like shaped.

After anisotropic etching, without making any modifications, wafer 1 is oxidized for forming second oxide layer 11 covering the walls and the bottom of initial trenches 10'', and the second silicon nitride layer 12 is deposited previously described, thus obtaining the intermediate structure shown in figure 15.

The previously described steps with reference to figures 4-8 are then carried out for forming final trenches 16 (which are 1-4 µm deeper than the initial trenches 10"), forming buried oxide region 22, and growing epitaxial layer 23.

Thereby, when the layers 11, 12 are formed, no steps are formed projecting towards the interior of the initial trenches 10'', and the subsequent non-masked anisotropic etching of layers 11, 12 does not uncover oxide portions of layer 11, thus preventing the problem described above with reference to figure 11.

Consequently, the described method makes it possible to produce an epitaxial layer 23 with a drastic reduction of the number of crystallographic defects, and thus SOI wafers having distinctly better electrical features than the SOI substrate described in the aforementioned patent application, at costs which are much lower than those of the methods currently used for production of substrates of this type.

Finally it is apparent that many modifications and variants can be made to the method described and illustrated here, all of which come within the invention, as defined in the attached claims.

## Claims

1. A method for manufacturing an SOI wafer, comprising, in sequence, the steps of:
- forming on a wafer (1) of monocrystalline semiconductor material, a mask (9') of material which is resistant to oxidation, forming first protective regions (7) covering first portions (8') of said wafer (1), said first portions (8') being separated reciprocally from second portions (8") not covered by said mask (9');
- isotropically etching said second portions (8") to form partial trenches (10') extending also partially into said first portions (8') below said first protective regions (7);
- anisotropically etching said wafer (1) below said partial trenches (10'), to form initial trenches (10") in said wafer (1), which are disposed between said first portions (8');
- forming, using said first protective regions (7), second protective regions (30) of an oxidation-resistant material, covering said first portions (8');
- forming, from said initial trenches (10"), final trenches (16) extending between, and laterally delimiting, said first portions (8');
- completely oxidising said first portions (8') except for upper portions (21), forming at least one continuous region (22) of buried oxide superimposed by said non-oxidised upper portions (21), and covered by said second protective regions (30);
- removing said second protective regions (30); and
- epitaxially growing a layer (23) of crystalline semiconductor material from said upper portions (21).

2. A method according to claim 1, **characterised in that** said partial trenches (10') are substantially cup-shaped.

3. A method according to claim 1 or 2, **characterised in that** said initial trenches (10'') are substantially funnel-like shaped.

4. A method according to any one of the preceding claims, **characterised in that** said step of forming a mask (9') comprises the steps of:
- forming a first oxide layer (4);
- forming a first nitride layer (5) above said first oxide layer;
- forming a second oxide layer (6) above said first nitride layer; and
- removing selective portions of said first and second oxide layer and said first nitride layer (4, 5, 6).

5. A method according to claim 4, **characterised in that** said second oxide layer (6) is a tetraethylorthosilicate oxide layer.

6. A method according to claim 1, **characterised in that** said second protective regions (30) are shaped as an overturned U.

7. A method according to claim 6, **characterised in that** said step of forming second protective regions (30) comprises the steps of:
- forming vertical lateral protective walls (12') made of non-oxidisable material, laterally covering said upper portions (21) and, together with said mask (9'), forming said overturned U shape.

8. A method according to claim 7, **characterised in that** before said step of forming vertical lateral protective walls (12'), a third oxide layer (11) is formed covering said mask (9'), base walls and lateral walls of said first trenches (10''), and **in that** said step of forming vertical lateral protective walls (12') comprises the steps of:
- depositing a second nitride layer (12) on said third oxide layer (11); and
- anisotropically etching said third oxide layer (11) and said second nitride layer (12).

## Patentansprüche

1. Verfahren zur Herstellung eines SOI (Silicon On Isolator) Wafers, das in der Reihenfolge folgende Schritte umfasst:
- Bilden einer Maske (9') aus einem Material, das gegen Oxidation beständig ist, auf einem Wafer (1) aus monokristallinem Halbleitermaterial, Bilden erster Schutzbereiche (7), die erste Teile (8') des Wafers (1) bedecken, wobei die ersten Teile (8') wechselseitig von zweiten Teilen (8"), die nicht von der Maske (9') bedeckt sind, getrennt sind;
- isotopes Ätzen der zweiten Teile (8''), um Teilgräben (10') zu bilden, die sich auch teilweise in die ersten Teile (8') unter dem ersten Schutzbereich (7) erstrecken;
- anisotropes Ätzen des Wafers (1) unter den Teilgräben (10'), um anfängliche Gräben (10") in dem Wafer (1) zu bilden, die zwischen den ersten Teilen (8') angeordnet sind;
- Bilden von zweiten Schutzbereichen (30) aus einem oxidationsbeständigen Material, das die ersten Teile (8') bedeckt, unter Verwendung der ersten Schutzbereiche (7);
- Bilden endgültiger Gräben (16), die sich zwischen den ersten Teilen (8') erstrecken und diese seitlich abgrenzen, aus den anfänglichen Gräben (10");
- vollständiges Oxidieren der ersten Teile (8') mit Ausnahme der oberen Teile (21), wobei mindestens ein zusammenhängender Bereich (22) aus verdecktem Oxid, das von den nichtoxidierten oberen Teilen (22) überlagert wird, und von den zweiten Schutzbereichen (30) bedeckt wird;
- Entfernen der zweiten Schutzbereiche (30); und
- epiktaktisches Aufwachsen einer Schicht (23) aus kristallinem Halbleitermaterial auf die oberen Teile (21).

2. Verfahren nach Anspruch 1, **dadurch gekennzeichnet, dass** die partiellen Gräben (10') im Wesentlichen becherförmig sind.

3. Verfahren nach Anspruch 1 oder 2, **dadurch gekennzeichnet, dass** die anfänglichen Gräben (10") im Wesentlichen trichterähnlich geformt sind.

4. Verfahren nach einem der vorhergehenden Ansprüche, **dadurch gekennzeichnet, dass** der Schritt des Bildens einer Maske (9') folgende Schritte umfasst:
- Bilden einer ersten Oxidschicht (4);
- Bilden einer ersten Nitridschicht (5) über der ersten Oxidschicht;
- Bilden einer zweiten Oxidschicht (6) über der ersten Nitridschicht; und
- Entfernen ausgewählter Bereiche der ersten und zweiten Oxidschicht und der ersten Nitridschicht (4, 5, 6).

5. Verfahren nach Anspruch 4, **dadurch gekennzeichnet, dass** die zweite Oxidschicht (6) eine Tetraethylorthosilicatoxidschicht ist.

6. Verfahren nach ein Anspruch 1, **dadurch gekennzeichnet, dass** die zweiten Schutzbereiche (30) wie ein umgekehrtes U geformt sind.

7. Verfahren nach Anspruch 6, **dadurch gekennzeichnet, dass** der Schritt des Bildens der zweiten Schutzbereiche (30) folgende Schritte umfasst:
- Bilden senkrechter seitlicher Schutzwände (12') aus nichtoxidierbarem Material, die seitlich die oberen Teile (21) bedecken und, zusammen mit der Maske (9'), die Form des umgekehrten U bilden.

8. Verfahren nach Anspruch 7, **dadurch gekennzeichnet, dass** vor dem Schritt des Bildens der senkrechten seitlichen Schutzwände (12'), eine dritte Oxidschicht (11) gebildet wird, welche die Maske (9'), die Bodenwände und die seitlichen Wände der ersten Gräben (10") bedeckt, und dass der Schritt des Bildens der senkrechten seitlichen Schutzwände (12') folgende Schritte umfasst:
- Abscheiden einer zweiten Nitridschicht (12) auf der dritten Oxidschicht (11); und
- anisotropes Ätzen der dritten Oxidschicht (11) und der zweiten Nitritschicht (12).

## Revendications

1. Procédé de fabrication d'une plaquette SOI, comportant, en série, les étapes consistant à :
- former sur une plaquette (1) en matériau semi-conducteur monocristallin, un masque (9') constitué d'un matériau qui est résistant à l'oxydation, former des premières régions protectrices (7) recouvrant des premières parties (8') de ladite plaquette (1), lesdites premières parties (8') étant séparées réciproquement de secondes parties (8") non recouvertes par ledit masque (9'),
- graver de manière isotrope lesdites secondes parties (8") pour former des tranchées partielles (10') s'étendant également partiellement dans lesdites premières parties (8') au-dessous desdites premières régions protectrices (7),
- graver de manière anisotrope ladite plaquette (1) au-dessous desdites tranchées partielles (10'), pour former des tranchées initiales (10") dans ladite plaquette (1), qui sont disposées entre lesdites premières parties (8'),
- former, en utilisant lesdites premières régions protectrices (7), des secondes régions protectrices (30) constituées d'un matériau résistant à l'oxydation, recouvrir lesdites premières parties (8'),
- former, depuis lesdites tranchées initiales (10"), des tranchées finales (16) s'étendant entre lesdites premières parties (8'), et délimitant latéralement celles-ci,
- oxyder complètement lesdites premières parties (8') à l'exception de parties supérieures (21), en formant au moins une région continue (22) d'oxyde enterré superposée par lesdites parties supérieures non oxydées (21), et recouverte par lesdites secondes régions protectrices (30),
- éliminer lesdites secondes régions protectrices (30), et
- faire croître par épitaxie une couche (23) de matériau semi-conducteur cristallin à partir desdites parties supérieures (21).

2. Procédé selon la revendication 1, **caractérisé en ce que** lesdites tranchées partielles (10') sont essentiellement en forme de coupelle.

3. Procédé selon la revendication 1 ou 2, **caractérisé en ce que** lesdites tranchées initiales (10") sont essentiellement en forme d'entonnoir.

4. Procédé selon l'une quelconque des revendications précédentes, **caractérisé en ce que** ladite étape de formation d'un masque (9') comporte les étapes consistant à :
- former une première couche d'oxyde (4),
- former une première couche de nitrure (5) au-dessus de ladite première couche d'oxyde,
- former une deuxième couche d'oxyde (6) au-dessus de ladite première couche de nitrure, et
- éliminer des parties sélectives desdites première et deuxième couches d'oxyde et de ladite première couche de nitrure (4, 5, 6).

5. Procédé selon la revendication 4, **caractérisé en ce que** ladite seconde couche d'oxyde (6) est une couche d'oxyde de tétraéthylorthosilicate.

6. Procédé selon la revendication 1, **caractérisé en ce que** lesdites secondes régions protectrices (30) sont mises en forme sous forme d'un U renversé.

7. Procédé selon la revendication 6, **caractérisé en ce que** ladite étape de formation de secondes régions protectrices (30) comporte les étapes consistant à :
- former des parois protectrices latérales verticales (12') constituées d'un matériau non oxydable, recouvrir latéralement lesdites parties supérieures (21) et, ensemble avec ledit masque (9'), former ladite forme de U renversé.

8. Procédé selon la revendication 7, **caractérisé en ce que**, avant ladite étape de formation de parois protectrices latérales verticales (12'), une troisième couche d'oxyde (11) est formée en recouvrant ledit masque (9'), des parois de base et des parois latérales desdites premières tranchées (10"), et **en ce que** ladite étape de formation de parois protectrices latérales verticales (12') comporte les étapes consistant à :
- déposer une seconde couche de nitrure (12) sur ladite troisième couche d'oxyde (11), et
- graver de manière anisotrope ladite troisième couche d'oxyde (11) et ladite seconde couche de nitrure (12).
